(19) Europäisches Patentamt
European Patent Office
Office européen des brevets

(11) **EP 2 101 360 A1**

(12) **EUROPEAN PATENT APPLICATION**
published in accordance with Art. 153(4) EPC

(43) Date of publication:
**16.09.2009 Bulletin 2009/38**

(51) Int Cl.:
*H01L 33/00* (2006.01)     *F21S 2/00* (2006.01)
*F21V 29/00* (2006.01)     *G02F 1/13357* (2006.01)
*F21Y 101/02* (2006.01)

(21) Application number: **07850690.4**

(22) Date of filing: **17.12.2007**

(86) International application number:
**PCT/JP2007/074202**

(87) International publication number:
**WO 2008/078587 (03.07.2008 Gazette 2008/27)**

(84) Designated Contracting States:
**AT BE BG CH CY CZ DE DK EE ES FI FR GB GR HU IE IS IT LI LT LU LV MC MT NL PL PT RO SE SI SK TR**

(30) Priority: **25.12.2006 JP 2006347246**

(71) Applicant: **Showa Denko K.K.**
**Tokyo 105-8518 (JP)**

(72) Inventor: **GOMI, Shuji**
**Chiba-shi**
**Chiba 267-0056 (JP)**

(74) Representative: **Strehl Schübel-Hopf & Partner**
**Maximilianstraße 54**
**80538 München (DE)**

(54) **LIGHT EMITTING DEVICE, DISPLAY DEVICE AND SOLID-STATE LIGHT EMITTING ELEMENT SUBSTRATE**

(57)     There is provided a light emitting device and the like that achieve efficient heat radiation while production cost is reduced. The backlight device includes a backlight frame, and LED substrates that each have plural LEDs and that are mounted on the backlight frame with mounting screws. In each LED substrate, heat transmission based circuits 300 are formed. The heat transmission based circuit 300 extends from heat transmission lands 310 where the respective LEDs are mounted, via through holes 340 and heat transmission circuits 320, to a contact heat transmission land 330 where the LED substrate is fixed to the backlight frame with the mounting screw.

FIG.5

**Description**

Technical Field

The present invention relates to a light emitting device and the like which are used for, for example, a liquid crystal display device.

Background Art

Recently, display devices such as liquid crystal display devices, in which a backlight is provided on a rear side of a display panel, are widely used.
As the backlight in a liquid crystal television or a liquid crystal monitor, what is called a direct-lighting type exists in which a light emitting device, such as a fluorescent tube, is arranged in a planar state beneath the liquid crystal panel (on a rear side thereof).
Technologies of the direct-lighting backlight using light emitting diodes (LEDs), which are one type of solid-state light emitting elements, as a light source, have been recently developed as a substitute for the backlight using the conventionally-used fluorescent tubes. In particular, in a case where the backlight for a liquid crystal TV having a large screen is configured with three-color LEDs corresponding to the three primary colors of red, blue, and green, a color reproduction range is made to be wider, and thus high image quality may be achieved.
If the backlight for the liquid crystal TV having a large screen is configured as a direct-lighting backlight, a large number of LEDs are necessary to be arrayed in order to obtain a large quantity of light. However, considerable amount of supplied energy is output as heat since the light-emission efficiency of the LED (conversion efficiency from the electric energy to light energy) is, for example, approximately 50% or less at present. As a result, the temperature of the LED is increased, which leads to further decrease of the light-emission efficiency and a shorter life time of the LED. To avoid this, it is desired to efficiently radiate heat from the LED.
A conventional art described in official gazettes regarding heat radiation from a LED light source or electronic parts is disclosed in patent documents 1 to 3, for example.
Patent document 1 discloses an art of an edge-lighting backlight in which a mounting metallic film, a metallic drive wiring, a metallic film pattern are formed on a mounting surface of a mounting substrate on which a LED module is mounted, and a metallic film for heat radiation is formed on a back surface of the mounting substrate, and metallic through holes are provided so as to connect the both surfaces, in order to suppress increase of the temperature of the LED module itself.
Patent document 2 discloses an art of a heat radiation device and a display device in which a heat sink is configured by a combination of a first heat sink and a second heat sink for an application display panel having a larger screen size than a reference display panel having a reference size. The first heat sink is formed by cutting a longitudinal shared heat sink material, which has a reference width conforming to the reference display panel and forms an attachment portion for a cooling fan, to the length conforming to the application display panel. On the other hand, the second heat sink compensates shortage of the heat radiation capacity necessary for the application display panel, which is not covered by the first heat sink. Accordingly, the heat radiation parts may cope with a change in the screen size of the display panel and a change in the number of the LEDs in response to the foregoing change. In addition, cost reduction and higher productivity may be achieved.
Patent document 3 discloses an art of a heat radiation member transmitting heat generated by electronic parts to a heat sink, in which a heat conductive filler is impregnated in holes in a layer of a metallic heat radiation substrate whose surface layer region on a side facing the heat sink has a porous or honey-comb structure. Here, the heat conductive filler has no flowability at room temperature, but obtains flowability when heat from the electronic parts causes the viscosity thereof to be lower. The heat radiation member having such a configuration increases a heat transmission property since the heat conduction filler that is softened and has flowability fills space between the heat radiation substrate and a heat transmission surface of a heat sink tube when a current is applied to the electronic parts.
Patent document 1: Japanese Patent Application Laid Open Publication No. 2006-11239
Patent document 2: Japanese Patent Application Laid Open Publication No. 2006-58486
Patent document 3: Japanese Patent Application Laid Open Publication No. 2005-347500

Disclosure of the Invention

Problems to be Solved by the Invention

As a heat radiation structure of a direct-lighting backlight in which a large number of LEDs are arrayed on a mounting substrate, there is a structure in which heat from the LEDs is made to escape through the mounting substrate to a heat radiation member (such as a frame and a heat sink) connected to the mounting substrate in order to suppress heating of the LEDs.
In such a heat radiation structure, it is necessary to make contact heat resistance from the mounting substrate to the radiation members as small as possible, in order to efficiently radiate heat from the LEDs.
Heat transmission between the members arranged so as to be in contact with each other is performed through a combination of "solid contact conduction," "air transmission" and "radiation." Here, the solid contact conduction is performed through portions actually contacting with each other in the microscopic sense, and the air transmission is performed through microscopic gaps (air space) formed between the members. Heat conduction efficiency of the solid contact conduction is overwhelmingly higher than the others. Therefore, the actual heat transmission depends on an area of the solid contact conduction (solid contact area). Thus, as the actual solid contact area is made to be larger, heat resistance between the entire members (contact heat resistance) is made to be smaller.

In other words, close contact between the mounting substrate and the heat radiation member with a larger area enables efficient heat radiation from the LEDs.

However, the connection between the mounting substrate and the heat radiation member is performed with an intermittent arrangement at a predetermined interval, and is performed by use of fixing members such as screws, in general. Accordingly, it is difficult to bring them into close contact with each other at the whole area, and a gap (air space) between the mounting substrate and the heat radiation member may be formed in some cases because of a warp of the mounting substrate. As a result, the contact heat resistance at the gap portion is increased, and thus the heat radiation is inhibited. In addition, heat remains (the temperature thereof is increased) in the air space at the gap, which leads to decrease of light-emission efficiency of the LED at this portion. This is a cause of unevenness of colors.

In order to prevent such a problem, for example, a heat conduction medium (hereinafter, referred to as a thermal interface material) such as a heat conduction sheet, a heat conduction compound, or a heat conduction grease is arranged between the mounting substrate and the heat radiation member, and thereby the solid contact area is increased and formation of the gap is prevented. However, in a configuration using such a thermal interface material, a material cost for the thermal interface material, and a work for arranging the thermal interface material therebetween are required, which cause a problem of increase of the production cost.

The present invention is achieved in order to address the above-described technical problems, and the subject of the present invention is to provide a light emitting device and the like for obtaining efficient heat radiation at low production cost.

Means for Solving the Problems

In order to attain the above object, there is provided a light emitting device according to the present invention including: a mounting substrate that has a plurality of solid-state light emitting elements and an electric circuit for supplying a drive current to the plurality of solid-state light emitting elements; a supporting member that supports the mounting substrate; and a mounting unit that mounts the mounting substrate on the supporting member. A heat transmission portion that transmits heat and a plurality of heat conducting paths that respectively conduct heat generated by the plurality of solid-state light emitting elements to the heat transmission portion are formed in the mounting substrate, and the mounting unit mounts the mounting substrate on the supporting member so that the heat transmission portion is brought into heat conductive contact with the supporting member.

Here, the plurality of heat conducting paths are set so that heat resistance thereof is approximately equal.

In addition, the plurality of heat conducting paths are formed on a side of the mounting substrate, the side being opposite to another side where the plurality of solid-state light emitting elements are provided, and the plurality of solid-state light emitting elements and the plurality of heat conducting paths are connected through a plurality of heat transmission penetration portions that heat-conductively penetrate the mounting substrate.

Moreover, the mounting unit fixes the mounting substrate to the supporting member so that the heat transmission portion of the mounting substrate is brought into heat conductive contact with the supporting member by a fixing member that penetrates the heat transmission portion.

There is provided a display device according to the present invention, including: a display panel on which an image is displayed; and a backlight that irradiates the display panel from a rear side of the display panel. The backlight includes: a mounting substrate having a plurality of solid-state light emitting elements and an electric circuit that supplies a drive current to the plurality of solid-state light emitting elements; a frame that supports the mounting substrate and in which the plurality of solid-state light emitting elements are arranged so as to face the display panel, as a direct-lighting configuration; and a fixing member that fixes the mounting substrate to the frame, the mounting substrate includes a fixing portion that fixes the mounting substrate to the frame, a heat transmission portion that is formed in the fixing portion and that transmits heat to the frame, and a plurality of heat conducting paths that respectively conduct heat generated by the plurality of solid-state light emitting elements to the heat transmission portion, and heat generated by the plurality of solid-state light emitting elements is transmitted from the heat transmission portion to the frame through the plurality of heat conducting paths by fixation of the mounting substrate to the frame with the fixing member.

Here, the plurality of heat conducting paths are set so that heat resistance thereof is approximately equal.

There is provided a solid-state light emitting element substrate according to the present invention, including: a mounting substrate; a plurality of solid-state light emitting elements that are mounted on the mounting substrate; an electric circuit for supplying a drive current to the plurality of solid-state light emitting elements, the electric circuit being formed in the mounting substrate; a fixing portion that is formed in the mounting substrate and that fixes the mounting substrate to a mounting target member; a heat transmission portion that is formed in the fixing member and that is in contact with the mounting target member; and a plurality of heat conducting paths that are formed in the mounting substrate and that respectively transmit heat generated by the plurality of solid-state light emitting elements to the heat transmission portion. The plurality of heat conducting paths are set so that heat resistance thereof is approximately equal.

Advantages of the Invention

The present invention having the above-described configuration is capable of forming a light emitting device and the like in which heat from the solid-state light emitting elements is efficiently radiated at low production cost in comparison with a case where the present configuration is not adopted.

Best Modes for carrying out the Invention

Hereinafter, exemplary embodiments of the present invention will be described in detail with reference to attached drawings.

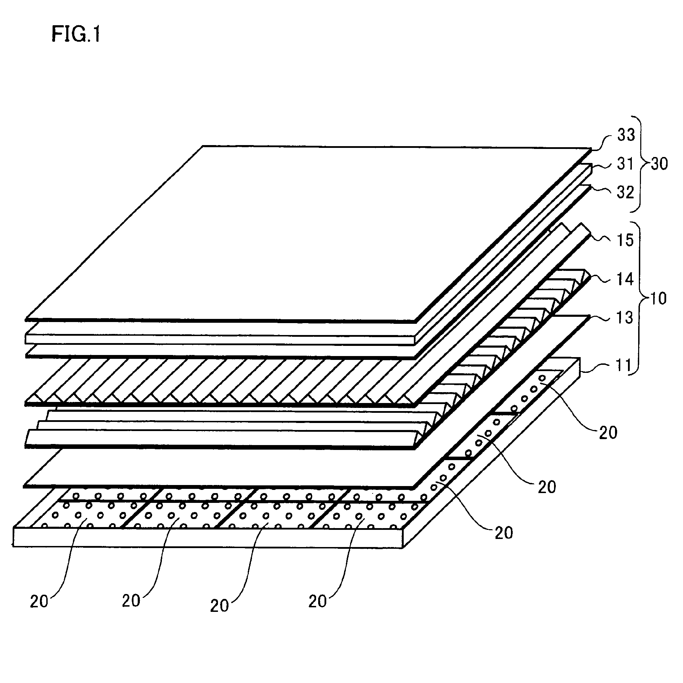

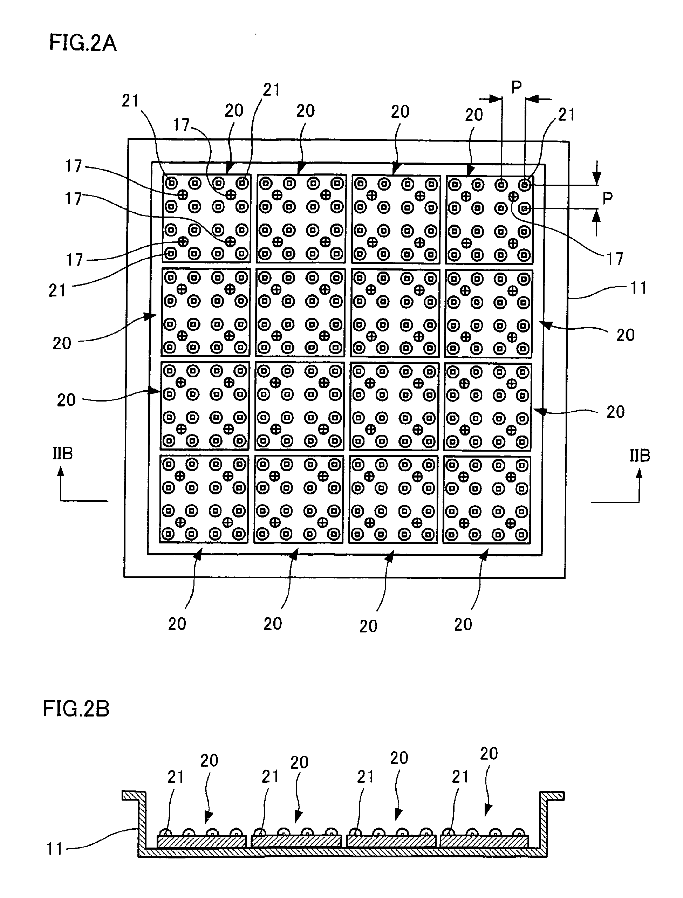

FIG. 1 is an exploded perspective view showing an overall configuration of a liquid crystal display device to which the exemplary embodiment is applied. FIGs. 2A and 2B show a backlight device 10, and specifically, FIG. 2A is a plan view of the backlight device 10 and FIG. 2B is a cross-sectional view taken along a line IIB-IIB in FIG. 2A. The liquid crystal display device shown in FIG. 1 is formed of a liquid crystal display module 30 as a display panel, and the backlight device (backlight) 10 as a light emitting device. In addition, peripheral members, such as a LSI for driving, not shown in the figure, are arranged in the liquid crystal display device.
The liquid crystal display module 30 includes a liquid crystal panel 31 formed of two glass boards sandwiching liquid crystal in between, and polarization plates (polarization filters) 32 and 33 that are stacked on the respective glass boards of the liquid crystal panel 31 and that restrict the oscillation of optical wave to a certain direction.
The liquid crystal panel 31 is configured so as to include various components not shown in the figure. For example, the two glass boards have display electrodes, active elements such as a thin film transistor (TFT) , liquid crystal, a spacer, sealant, an orientation film, a common electrode, a protective film, a color filter, and others, none of which is shown in the figure.
The backlight device 10 includes a backlight frame (frame, mounting target member) 11 as a supporting member, and LED substrates 20 as mounting substrates that are mounted inside the backlight frame 11. Here, each of the LED substrates 20 includes plural LEDs 21 that are solid-state light emitting elements. Moreover, in a front side of the LED substrate 20, the backlight device 10 includes a diffusion plate (or a diffusion film) 13 which is a transparent plate (or a film) for scattering and diffusing light to equalize the lightness over the entire surface, and prism sheets 14 and 15 as a diffraction grating film that has a light collection effect to the front.
By this configuration, the backlight device 10 configures a so-called direct lighting backlight in which the LEDs 21 are substantially uniformly arrayed on the rear portion of the liquid crystal display module 30 entirely.
Note that, a structural unit of the backlight device 10 is selected in an arbitrary way. For example, the unit including only the backlight frame 11 with the LED substrates 20 may be called as the "backlight" and distributed so as not to include a laminate of optical compensation sheets such as the diffusion plate 13 and the prism sheets 14 and 15.
The backlight frame 11 is formed into a box shape whose front side (side facing the liquid crystal display module 30) is open, and is made of a material having a good strength and heat conduction, such as aluminum, magnesium, iron, or metallic alloy thereof. The plane shape thereof is a rectangle having a size corresponding to the liquid crystal display module 30. In addition, for example, a polyester film or the like having a high performance of reflecting white light adheres to the inside of the backlight frame 11, which functions as a reflector. On the rear portion or the side portions, a heat sink structure including a cooling fin and the like for exhaust heat may be provided as necessary.
As shown in FIGs. 2A and 2B, the plural LED substrates 20 (16 LED substrates 20 in the present exemplary embodiment) are adjacently arranged in the backlight frame 11, and are each fixed to the backlight frame 11 by use of mounting screws 17 as plural fixing members. That is, the mounting screws 17 form a mounting unit in the present invention. In the present exemplary embodiment, four mounting screws 17 are provided for each LED substrate 20.
On the upper side of each LED substrate 20, plural LEDs 21 (16 LEDs 21 in the present exemplary embodiment) are arranged. Hereinafter, the side where the LEDs 21 are mounted is referred to as a front surface side of the LED substrate 20.
Note that, although not shown in the figure in detail, the plural LEDs 21 includes light emitting diodes that emit red light, green light, and blue light, respectively, which are arranged in accordance with a certain rule. By mixing these different color light beams from the light emitting diodes, a light source having a wide color reproduction range is obtainable.
Note that, each LED 21 may include one or more LEDs that each emit red, green or blue light, or a pseudo-white light emitting element that emits pseudo white light by, for example, a combination of a single LED that emits blue-violet light and a YAG phosphor may be used as the LED 21. Further, the LED 21 may be configured to include plural LEDs that emit red, green and blue light, respectively, and to emit white light by a combination of these LEDs.
The plural LED substrates 20 described above are mounted on the backlight frame 11 in order, and thus the LEDs 21 are uniformly arranged on the overall portion of the backlight frame 11. This configuration allows all of the LEDs 21 existing in the backlight frame 11 to emit backlight (light) having uniform brightness and chromaticity. Note that, the number of the LED substrates 20 and the like may be set as necessary.

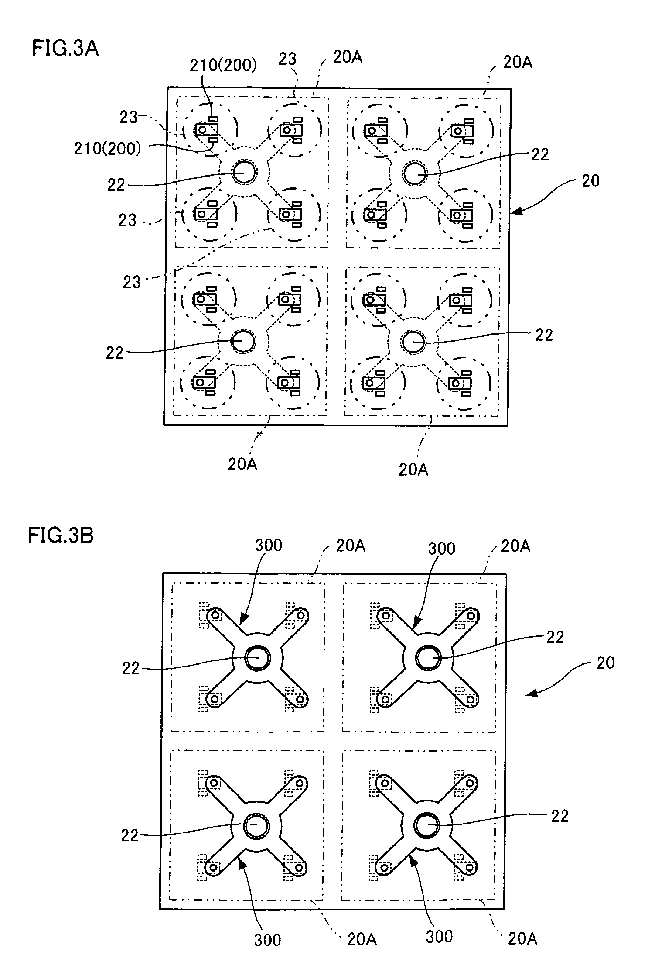

A detail description will be given of the LED substrates 20 with reference to FIGs. 2A and 2B described above, and FIGs. 3A to 7.

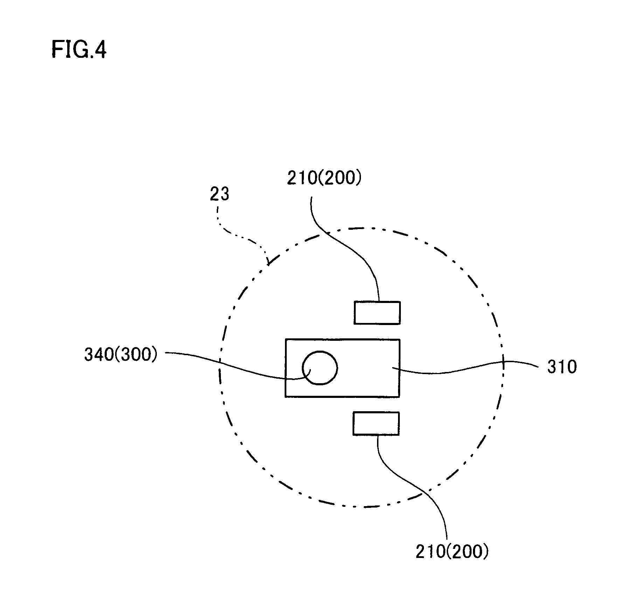

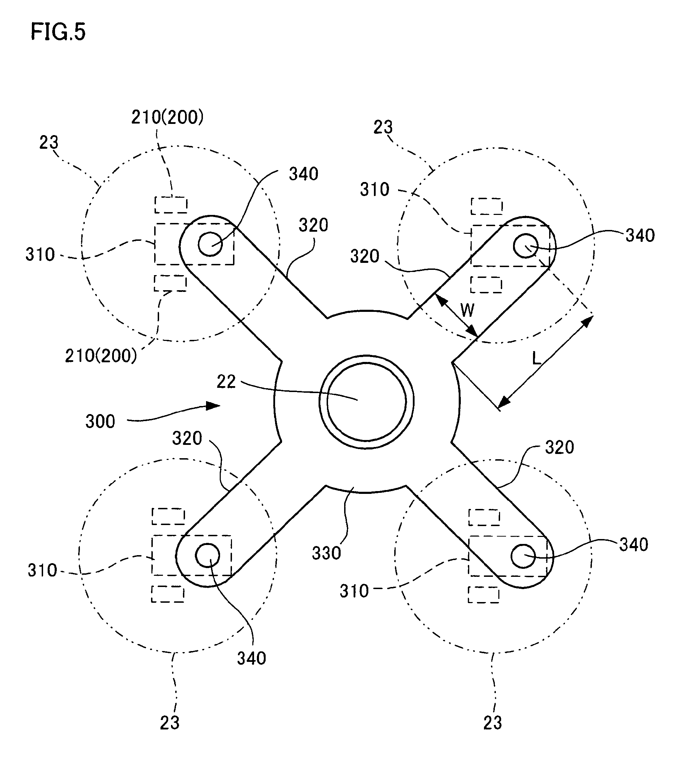

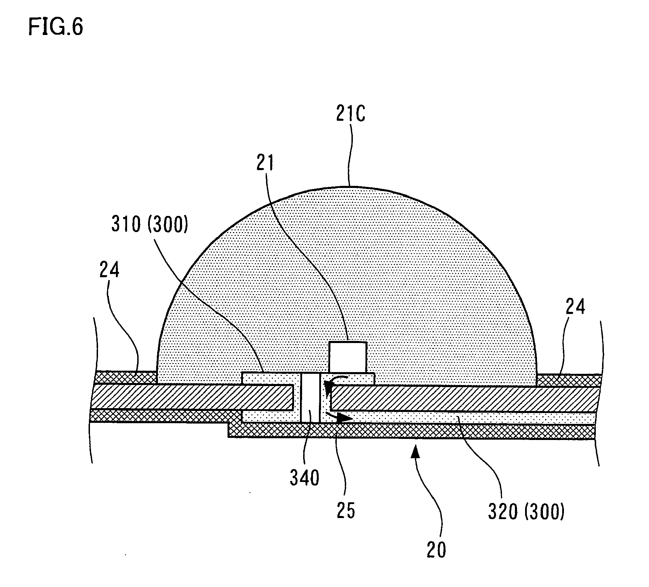

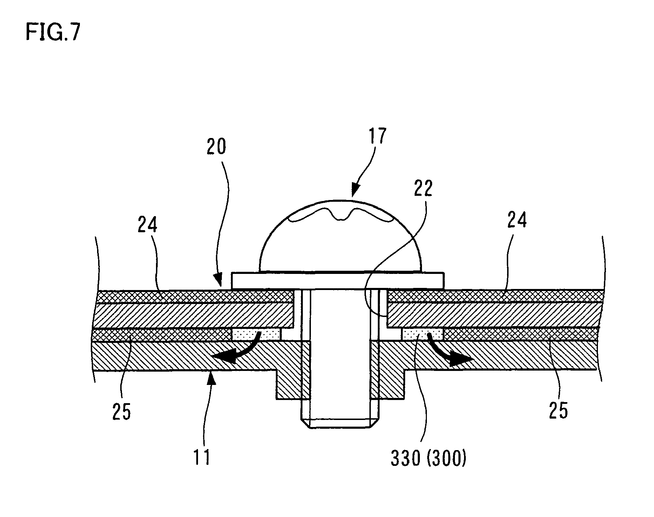

FIGs. 3A and 3B show the LED substrate 20. Specifically, FIG. 3A is a plan view of the LED substrate 20 (a view of the LED substrate 20 on the front surface side) in a state where the LEDs 21 are not mounted, and FIG. 3B is a rear view (a view on the back surface side) of the LED substrate 20 . FIG. 4 is an enlarged view of a mounting portion 23 of the LED substrate 20 on the front surface side where the LED 21 is to be mounted. FIG. 5 is an enlarged view of a heat transmission circuit 320 formed on the back surface side of the LED substrate 20. Further, FIG. 6 is an enlarged cross-sectional view of the mounting portion 23 where the LED 21 is mounted. FIG. 7 is an enlarged cross-sectional view of a fastening portion of the mounting screw 17.

The LED substrate 20 is a substrate for electronic devices, which is made of glass-cloth-based epoxy resin, and the LED substrate 20 is formed into a predetermined shape (a square in the present exemplary embodiment) with a predetermined thickness.

As shown in FIGs . 2A and 2B, plural LEDs 21 are mounted on the front surface side of the LED substrate 20. In the present exemplary embodiment, 16 LEDs 21 are mounted.

These LEDs 21 are mounted on the mounting portions 23 of the LED substrate 20, respectively, and are arranged at equal intervals (LED interval: P) in the length and width directions. The distance from the outer edge of the LED substrate 20 to the outermost LEDs 21 is set at a distance less than half of the LED interval P. Accordingly, when the plural LED substrates 20 are arranged in order, the LEDs 21 on the LED substrates 20 adjacent to each other may be set to have the LED interval P.

Mounting holes 22 for fastening the LED substrate 20 to the backlight frame 11 with the mounting screws 17 are formed at predetermined positions of the LED substrate 20. In the present exemplary embodiment, four mounting holes 22 are provided. The forming portions of the mounting holes 22 are fixing portions of the LED substrate 20 in the present invention.

Further, the LED substrate 20 has electric based circuits (electric circuits) 200 for supplying a drive current to the respective LEDs 21, and heat transmission based circuits 300 for conducting heat generated by the respective LEDs 21. Note that, these electric based circuits 200 and heat transmission based circuits 300 are formed with the following method. Firstly, metallic foil layers made of copper, copper alloy or the like with a predetermined thickness are respectively formed on the front and back surface sides of the LED substrate 20. Then, the metallic foil layers are etched to have predetermined shapes in an etching process similarly to a general print wiring circuit forming process.

Each electric based circuit 200 includes a terminal land 210 to which the corresponding LED 21 is electrically connected, and an electric wiring circuit (not shown in the figure) connected to the terminal lands 210. The terminal lands 210 and the electric wiring circuit are formed on the front surface side of the LED substrate 20. A pair of the terminal lands 210 is provided at a portion (the mounting portion 23) of the LED substrate 20 where the corresponding LED 21 is mounted, as shown in FIG. 4 as the enlarged view. Specifically, the terminal lands 210 forming the pair are provided at a predetermined interval so as to sandwich the center of the mounting portion 23 (a portion directly under the LED 21 to be mounted). Leads of the corresponding LED 21 are connected to the terminal lands 210 forming the pair. The electric wiring circuit is connected to these terminal lands 210 to supply driving electric power to the LEDs 21.

As shown in FIGs. 4 and 5 as the enlarged views, each of the heat transmission based circuits 300 is formed of heat transmission lands 310 formed on the front surface side of the LED substrate 20, heat transmission circuits 320 as heat conducting paths formed on the back surface side of the LED substrate 20, a contact heat transmission land 330 as a heat transmission portion, and through holes 340 as heat transmission penetration portions that heat-conductively connect the heat transmission lands 310 and the heat transmission circuits 320.

Each of the heat transmission lands 310 extends, with width corresponding to each LED 21, from a portion where the LED 21 at the center of the mounting portion 23 is arranged (a portion between the pair of the terminal lands 210) to a forming portion of the through hole 340 which is described later.

Each of the through holes 340 is formed at a position that is eccentric, by a predetermined amount, from the center of the corresponding mounting portion 23 in a direction orthogonal to an arrangement direction of the terminal lands 210. In addition, each of the through holes 340 penetrates between the front and back surfaces of the LED substrate 20 and has a predetermined diameter (for example, 0.3 to 0.5 mm). At the inner circumferential surface thereof, a metallic plating layer (for example, a copper plating layer) is formed, and this metallic plating layer heat-conductively connects the heat transmission land 310 on the front surface side of the LED substrate 20 and the heat transmission circuit 320 on the back surface side of the LED substrate 20.

Note that, the heat transmission penetration portion in the present invention is not restricted to a configuration such as the through hole 340. For example, another configuration is acceptable in which electrically conductive paste or the like is filled in each through hole 340 of the present exemplary embodiment, and then each through hole 340 is blocked by a solder mask (in other words, each through hole 340 does not penetrate like a hole). Alternatively, a configuration may be acceptable in which a wire-shaped heat transmission member is provided so as to penetrate the LED substrate 20. In essence, it is only necessary to heat-conductively connect the heat transmission land 310 on the front surface side of the LED substrate 20 and the head transmission circuit 320 on the back surface side of the LED substrate 20.

In the present exemplary embodiment, each through hole 340 is provided at a position eccentric from the center of the mounting portion 23. However, the position of the through hole 34 is not restricted to the above-described one. The position of the through hole 34 may be the center of the mounting portion 23 (the portion directly under the mounting position of the corresponding LED 21) or the like as a matter of course. In such a case, the size of the heat transmission land 310 may correspond to that of the LED 21.

Each of the heat transmission circuits 320 is formed so as to connect an opening portion of the corresponding through hole 340 on the back surface side of the LED substrate 20 and the contact heat transmission land 330.

The contact heat transmission land 330 is formed into a circle concentric with the mounting hole 22, and is formed around the mounting hole 22. The diameter thereof is set so as to cover an area where the mounting screw 17 inserted into the mounting hole 22 is in close contact with the LED substrate 20 at predetermined pressure when the LED substrate 20 is fastened to the backlight frame 11 by the mounting screw 17. For example, the diameter is set so as to be approximately equal to a diameter of a screw head of the mounting screw 17 or a diameter of a washer to be used. For example, in case of a M3 sems screw with a plain washer (polished circle), the diameter may be set at around $\Phi$ 7 mm.

In the present exemplary embodiment, one mounting hole 22 is provided to each area (an unit area 20A) formed into a square obtained by equally dividing the square LED substrate 20 into four in the longitudinal and lateral directions. The position of the mounting hole 22 is set at an approximately center of four LEDs 21 arranged in the unit area 20A. More precisely, the mounting hole 22 is set at a position so that the linear distances from the respective through holes 340 formed at the mounting portions 23 of the LEDs 21 in the unit area 20A to the mounting hole 22 are equal. In the unit area 20A, the four LEDs 21 are arranged so as to form a square, and the mounting hole 22 may be provided at the center of the square while satisfying the above condition.

By this configuration, each of the heat transmission circuits 320 which connect between the contact heat transmission land 330 and the respective through holes 340 of the mounting portions 23 in the unit area 20A, has linearly equal length (circuit length: L). In addition, each heat transmission circuit 320 is set to have the same width W. Moreover, the thickness of the heat transmission circuits 320 (thickness of the metallic foil forming the heat transmission circuits 320) is equal. Accordingly, the respective heat transmission circuits 320 have the same length and the cross-sectional area, and thus have the same heat resistance from the respective through holes 340 to the contact heat transmission land 330. That is, the respective heat transmission circuits 320 are set to have the same length in view of heat conduction.

By adopting the above-described configuration of the heat transmission based circuit 300, heat conducting paths are formed, which extend from the respective heat transmission lands 310 on which the LEDs 21 are mounted to the contact heat transmission land 330 via the respective through holes 340 and the respective heat transmission circuits 320. In the present exemplary embodiment, the heat conducting paths for the four LEDs 21 arranged in the unit area 20A are concentrated on the one contact heat transmission land 330.

Note that, non-electrically conductive resin covers the front surface side of the LED substrate 20 except the mounting portions 23 to form a protective insulation film 24 (shown in FIGs . 6 and 7) . Also, non-electrically conductive resin covers the back surface side of the LED substrate 20 except the contact heat transmission land 330 (except a peripheral area of the mounting hole 22) to form a protective insulation film 25 (shown in FIGs. 6 and 7).

The LEDs 21 are mounted on the mounting portions 23 of the LED substrate 20, respectively, as described above.

The LEDs 21 are mounted on the mounting portions 23 in a manner that the leads (not shown in the figure) are connected to the corresponding terminal lands 210 while the LEDs 21 are in heat conductive contact with the heat transmission lands 310 at the mounting portions 23, as shown in FIG. 6 as the enlarged cross-sectional view. In addition, a hemispherical cover 21C, which is made of transparent resin, is formed at an outer periphery of each LED 21. Note that, in the present exemplary embodiment, the covers 21C are formed after LED chips are mounted on the LED substrate 20, but the forming method is not restricted to this. Alternatively, such a configuration may be formed by mounting LED lamps, each of which includes a LED chip and the cover 21C as a unit, on the LED substrates 20.

Then, the above-described LED substrate 20 is fastened to the backlight frame 11 with the mounting screws 17 inserted into the mounting holes 22, as shown in the enlarged cross-sectional view of FIG. 7. Thereby, the contact heat transmission land 330 around the mounting hole 22 comes into pressure contact with the front surface of the backlight frame 11. That is, the LED substrate 20 is slightly deformed by the fixing pressure from the mounting screw 17, and the contact heat transmission land 330 comes into contact with the front surface of the backlight frame 11 with predetermined pressure, although the back surface side of the LED substrate 20 is not smooth and flat because of the existence of the heat transmission circuit 320 and the protective insulation film 25, as exaggeratedly shown in FIG. 6.

As a result, heat easily flows from the contact heat transmission land 330 to the backlight frame 11, as shown with arrows in FIG. 7. That is, as the contact pressure gets higher in response to the pressure contact between the contact heat transmission land 330 and the backlight frame 11, air space existing between them gets thinner while the solid contact area gets increased. This leads to smaller contact heat resistance and easier heat conduction.

Note that, the contact heat transmission land 330 shown in FIG. 7 is formed in a vicinity of the mounting hole 22 so as to be in a range slightly larger (approximately 0. 5 mm to 1.0 mm in radius) than the hole diameter of the mounting hole 22. This is because of preventing the metallic foil of the contact heat transmission land 330 from peeling when the mounting hole 22 is formed in the LED substrate 20 by pressing or the like.

In the backlight device 10 including the LED substrates 20 each having the above-described configuration, heat generated by the LED 21 is conducted through the heat transmission based circuit 300 (the heat transmission land 310, the through hole 340, the heat transmission circuit 320 and the contact heat transmission land 330) to be radiated to the backlight frame 11. In other words, the heat generated by the LED 21 is guided by the heat transmission based circuit 300 to the fastening portion with the mounting screw 17 that is in contact with the backlight frame 11 with high pressure so as to radiate the heat.

Accordingly, the heat from the LED 21 is made to efficiently escape to the backlight frame 11 without any thermal interface material, such as a heat conductive sheet, a heat conductive compound, or a heat conductive grease, which is arranged between the LED substrates 20 and the backlight frame 11. Thus, the temperature of the LED 21 is prevented from increasing. Therefore, the material cost for the thermal interface material and the work for arranging the thermal interface material therebetween are not necessary, which leads to reduction of the production cost.

The respective heat transmission circuits 320 connecting respective four LEDs 21 and the one contact heat transmission land 330 in the unit area 20A have the equal heat resistance (and also have the equal actual length), and thus the heat from the respective LEDs 21 arranged in the unit area 20A may be made to escape equally. In addition, the heat resistance of the heat transmission circuits 320 is equal in all of the unit areas 20A, and thereby uniform heat radiation from all of the LEDs 21 arranged in the LED substrate 20 is achievable. In addition, these conditions are applied to all of the plural LED substrates 20 mounted on the backlight frame 11.

By this configuration, the temperature distribution is averaged by the uniform heat radiation from all of the LEDs 21 in the backlight device 10, and thereby unevenness of color due to local heat concentration (a hot spot) may be prevented.

Here, the width of the heat transmission circuit 320 is preferably wide in view of the heat conduction. However, if it is made to be excessively wider, a hot spot may be generated in some cases since a gap (air space) between the backlight frame 11 and the LED substrate 20 is heated. Thus, the width is to be set so as to avoid such a situation.

That is, since the LED substrate 20 is fastened to the backlight frame 11 with the four mounting screws 17, it is difficult to make the entire back surface of the LED substrate 20 close contact with the backlight frame 11. Accordingly, the gap (air space) is formed between the backlight frame 11 and the LED substrate 20. Suppose that the entire back surface of the LED substrate 20 is made of copper foil. In this case, heat of the copper foil heats the air space of the gap (heat is radiated from the copper foil to the air). The heat transmission through the air space has large heat resistance, and therefore the heat is not promptly transmitted to the backlight frame 11. Thus, it causes the temperature of the air space to increase, and a so-called hot spot is generated. As a result, the light-emission efficiency of the LED 21 is decreased, which leads to the unevenness of color.

In order to prevent the hot spot caused by such an air space of the gap, it is preferable that the surface area of the heat transmission circuit 320 should be smaller. Thus, each heat transmission circuit 320 connects the corresponding through hole 340 and the contact heat transmission land 330 at the shortest distance (that is, linearly), and the width thereof is set in consideration of the heat conduction and prevention of the hot spot.

On the other hand, the thickness of the heat transmission circuit 320 is preferably configured so as to be as thick as possible in order to make the cross-sectional area thereof larger and in order to make the heat conduction efficiency increased. Even if the heat transmission circuit 320 is configured to be thicker, heat conduction to the air space of the gap therebetween is not increased.

In the present exemplary embodiment, even if the gap (air space) is formed between the backlight frame 11 and the LED substrate 20, the air space is difficult to be heated and the hot spot is difficult to be generated, since the heat is guided to the contact heat transmission land 330 through the heat transmission circuits 320 each having a limited surface area so as to escape to the backlight frame 11.

In addition, in the present exemplary embodiment, the back surface of the LED substrate 20 is covered with the protective insulation film 25 that is made of resin having small heat conductivity. Also by this configuration, the heat conduction from the heat transmission circuit 320 to the air space of the gap is suppressed, and thus heat accumulation at the gap portion is prevented.

As described above, even if the gap is formed between the backlight frame 11 and the LED substrate 20, the hot spot is not generated, and the heat from the LEDs 21 is caused to be efficiently conducted to the backlight frame 11 through the heat transmission circuit 320 and the contact heat transmission land 330 so as to be radiated.

Note that, the present invention is not restricted to the above-described exemplary embodiment. For example, the number of the LEDs 21 arranged in the LED substrate 20, the number of the mounting holes 22, the number of the heat transmission circuit 320 connected to the one contact heat transmission land 330 and the like are changeable as necessary.

In addition, the mounting unit of the LED substrate 20 to the backlight frame 11 is not restricted to a screw (the mounting screw 17) as long as the mounting unit may fix the LED substrate 20 (contact heat transmission land 330) to the backlight frame 11 in a state where the LED substrate 20 is in pressure contact with the backlight frame 11. For example, a rivet made of metal, a canoe clip made of resin or the like may be used.

Depending on the arrangement of the LEDs 21 and the mounting holes 22 for mounting the LED substrate 20 to the backlight frame 11, the length of the heat transmission circuits 320 of the heat transmission based circuit 300 for the respective LEDs 21 may not be equally set in some cases.

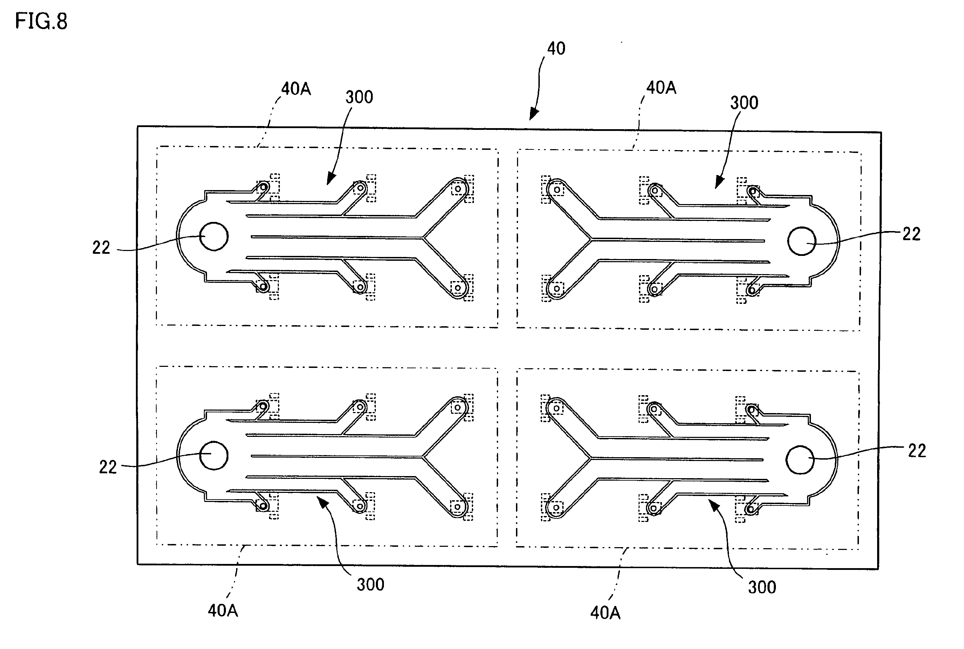

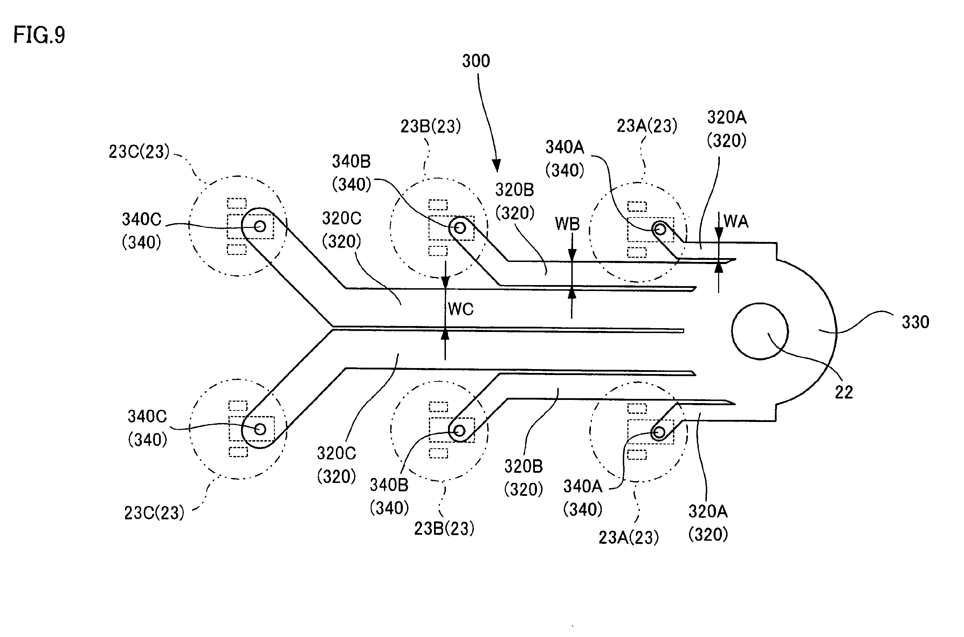

Next, such an example in which the length of the heat transmission circuits 320 is different is described, with reference to FIGs. 8 and 9. FIG. 8 is a rear view of a LED substrate 40 having the heat transmission circuits 320 whose length is different from each other, and FIG. 9 is an enlarged view of the heat transmission circuit 320. Note that, with regard to the same components in these figures as those in the aforementioned exemplary embodiment, the same reference numerals are applied thereto and the description thereof is omitted.

The LED substrate 40 shown in FIG. 8 has a plain shape as a rectangle, and is provided with mounting holes 22 in the vicinity of four corners thereof, respectively. That is, the LED substrate 40 is mounted on the backlight frame not shown in the figure, through the four mounting holes 22.

The LED substrate 40 is divided into four equal sections as unit areas in the longitudinal and lateral directions so as to correspond to the respective mounting holes 22. In each unit area 40A, six mounting portions 23 (23A, 23B and 23C) are provided. Here, to each mounting portion 23, a LED (not shown in the figure) is mounted. That is, six LEDs are mounted in each unit area 40A.

In the unit area 40A, the three mounting portions 23 are arrayed in a line at a predetermined interval in the lateral direction in the figure. Two lines each having the above configuration are arranged at a predetermined interval in the longitudinal direction.

The mounting hole 22 is arranged around a midway between the two mounting portions 23A located in the vicinity of one side edge of the LED substrate 40.

Accordingly, the distances between the contact heat transmission land 330 formed around the mounting hole 22 and the respective mounting portions 23A, 23B and 23C (through holes 340A, 340B and 340C) are different in three steps. That is, there are two of the closest mounting portions 23A, two mounting portions 23B having the middle distance, and two of the farthest mounting portions 23C.

In this configuration, the heat transmission circuits 320 (320A, 320B and 320C), which connect the respective through holes 340 (340A, 340B and 340C) of the mounting portions 23 (23A, 23B and 23C) with the contact heat transmission land 330, are set to have approximately equal heat resistance, since the cross-sectional area thereof is different in accordance with the length thereof.

That is, the theoretical equation of the heat conduction is given as follows:

$$Q = K \times A \times \Delta t \; / \; L,$$

where

Q: heat quantity (W)
K: heat conductivity (W/mK)
A: cross-sectional area (m$^2$)
$\Delta t$: temperature difference (K)
L: length (m).

In other words, the heat quantity to be conducted Q is proportional to the cross-sectional area A, and is inversely proportional to the length (distance) L.

Note that, the heat resistance R (degrees C/W) in this case is as follows:

$$R = \Delta t \; / \; Q.$$

On the basis of the above-described relationship, the cross-sectional area of the heat transmission circuits 320 is changed so that the heat quantity to be conducted (heat resistance) is approximately equalized in accordance with the length of the heat transmission circuits 320 (distances between the contact heat transmission land 330 and the respective through holes 340 of the mounting portions 23).

The change of the cross-sectional area of the heat transmission circuits 320 is achieved by changing the width of the heat transmission circuits 320 since the thickness of the heat transmission circuits 320 formed of copper foil or the like is difficult to be changed. That is, if the width of the heat transmission circuits 320 is set with reference to the width (WA) of the heat transmission circuits 320A connected to the through holes 340A of the closest mounting portions 23A at the shortest distance, the width (WB) of the heat transmission circuits 320B connected to the through holes 340B of the mounting portions 23B at the middle distance is set to be wider than the width (WA), and the width (WC) of the heat transmission circuits 320C connected to the through holes 340C of the farthest mounting portions 23C is set to be further wider than the others, at a rate according to the distance. Note that, the change of the cross-sectional area may be achieved by changing the thickness of the heat transmission circuits 320 as a matter of course, and in addition, it may be achieved by changing both the width and the thickness thereof.

By adopting the LED substrate 40 having such a configuration, heat resistance of the respective heat transmission circuits 320 connecting the one contact heat transmission land 330 and the respective LEDs arranged at the six mounting portions 23 in the unit area 40A may be set to be approximately the same. Accordingly, heat from the respective LEDs disposed in the unit area 40A is made to uniformly escape, and thus occurrence of the local heat concentration (hot spot) may be prevented. In addition, by adopting such a configuration, the restriction regarding the arrangement of the mounting holes 22 (contact heat transmission lands 330) and the LEDs is reduced, and thus the degree of design freedom may be increased.

Brief Description of the Drawings

FIG. 1 is an exploded perspective view showing an overall configuration of a liquid crystal display device to which the exemplary embodiment is applied;
FIGs. 2A and 2B show a backlight device, and specifically, FIG. 2A is a plan view of the backlight device and FIG. 2B is a cross-sectional view taken along a line IIB-IIB in FIG. 2A;
FIG. 3A is a plan view of the LED substrate, and FIG. 3B is a rear view of the LED substrate;
FIG. 4 is an enlarged view of a mounting portion where the LED is to be mounted;
FIG. 5 is an enlarged view of a heat transmission circuit;
FIG. 6 is an enlarged cross-sectional view of the mounting portion where the LED is mounted;
FIG. 7 is an enlarged cross-sectional view of a fastening portion of the mounting screw;
FIG. 8 is a rear view of a LED substrate having the heat transmission circuits whose length is different from each other; and
FIG. 9 is an enlarged view of the heat transmission circuit of the LED substrate shown in FIG. 8.

Description of Reference Numerals and Signs

10... backlight device (light emitting device, backlight), 11... backlight frame (supporting member, frame), 17... mounting screw (mounting unit, fixing member), 20, 40... LED substrate (mounting substrate), 21... LED (solid-state light emitting element), 22... mounting hole (fixing portion), 30... liquid crystal display module (display panel), 300 ... heat transmission based circuit, 310... heat transmission land, 320 ... heat transmission circuit (heat conducting path), 330... contact heat transmission land (heat transmission portion), 340... through hole (heat transmission penetration portion)

**Claims**

1. A light emitting device comprising:

a mounting substrate that has a plurality of solid-state light emitting elements and an electric circuit for supplying a drive current to the plurality of solid-state light emitting elements;
a supporting member that supports the mounting substrate; and
a mounting unit that mounts the mounting substrate on the supporting member, wherein
a heat transmission portion that transmits heat and a plurality of heat conducting paths that respectively conduct heat generated by the plurality of solid-state light emitting elements to the heat transmission portion are formed in the mounting substrate, and
the mounting unit mounts the mounting substrate on the supporting member so that the heat transmission portion is brought into heat conductive contact with the supporting member.

2. The light emitting device according to claim 1, wherein the plurality of heat conducting paths are set so that heat resistance thereof is approximately equal.

3. The light emitting device according to claim 2, wherein the plurality of heat conducting paths are formed on a side of the mounting substrate, the side being opposite to another side where the plurality of solid-state light emitting elements are provided, and the plurality of solid-state light emitting elements and the plurality of heat conducting paths are connected through a plurality of heat transmission penetration portions that heat-conductively penetrate the mounting substrate.

4. The light emitting device according to claims 1 to 3, wherein the mounting unit fixes the mounting substrate to the supporting member so that the heat transmission portion of the mounting substrate is brought into heat conductive contact with the supporting member by a fixing member that penetrates the heat transmission portion.

5. A display device comprising:

a display panel on which an image is displayed; and
a backlight that irradiates the display panel from a rear side of the display panel, wherein the backlight includes:

> a mounting substrate having a plurality of solid-state light emitting elements and an electric circuit that supplies a drive current to the plurality of solid-state light emitting elements;
> a frame that supports the mounting substrate and in which the plurality of solid-state light emitting elements are arranged so as to face the display panel, as a direct-lighting configuration; and
> a fixing member that fixes the mounting substrate to the frame,

the mounting substrate includes a fixing portion that fixes the mounting substrate to the frame, a heat transmission portion that is formed in the fixing portion and that transmits heat to the frame, and a plurality of heat conducting paths that respectively conduct heat generated by the plurality of solid-state light emitting elements to the heat transmission portion, and

heat generated by the plurality of solid-state light emitting elements is transmitted from the heat transmission portion to the frame through the plurality of heat conducting paths by fixation of the mounting substrate to the frame with the fixing member.

6. The display device according to claim 5, wherein the plurality of heat conducting paths are set so that heat resistance thereof is approximately equal.

7. A solid-state light emitting element substrate comprising:

> a mounting substrate;
> a plurality of solid-state light emitting elements that are mounted on the mounting substrate;
> an electric circuit for supplying a drive current to the plurality of solid-state light emitting elements, the electric circuit being formed in the mounting substrate;
> a fixing portion that is formed in the mounting substrate and that fixes the mounting substrate to a mounting target member;
> a heat transmission portion that is formed in the fixing member and that is in contact with the mounting target member; and
> a plurality of heat conducting paths that are formed in the mounting substrate and that respectively transmit heat generated by the plurality of solid-state light emitting elements to the heat transmission portion, wherein
> the plurality of heat conducting paths are set so that heat resistance thereof is approximately

equal.

FIG.1

FIG.2A

FIG.2B

FIG.3A

210(200)    23    ⌐ 20A          ⌐ 20A

23⁻

210(200)

22

23

23

22    22

22

20

FIG.3B

300    ⌐ 20A    300    ⌐ 20A

22    22

20

22    22

300    ⌐ 20A    300    ⌐ 20A

FIG.4

210(200)

23

340(300)

310

210(200)

FIG.5

FIG.6

FIG.7

FIG.8

FIG.9

EP 2 101 360 A1

**INTERNATIONAL SEARCH REPORT**

| International application No. |
| --- |
| PCT/JP2007/074202 |

A.  CLASSIFICATION OF SUBJECT MATTER
*H01L33/00*(2006.01)i, *F21S2/00*(2006.01)i, *F21V29/00*(2006.01)i, *G02F1/13357*
(2006.01)i, *F21Y101/02*(2006.01)n

According to International Patent Classification (IPC) or to both national classification and IPC

B.  FIELDS SEARCHED

Minimum documentation searched (classification system followed by classification symbols)
H01L33/00, F21S2/00, F21V29/00, G02F1/13357, F21Y101/02

Documentation searched other than minimum documentation to the extent that such documents are included in the fields searched
Jitsuyo Shinan Koho        1922-1996   Jitsuyo Shinan Toroku Koho    1996-2007
Kokai Jitsuyo Shinan Koho  1971-2007   Toroku Jitsuyo Shinan Koho    1994-2007

Electronic data base consulted during the international search (name of data base and, where practicable, search terms used)

C.  DOCUMENTS CONSIDERED TO BE RELEVANT

| Category* | Citation of document, with indication, where appropriate, of the relevant passages | Relevant to claim No. |
| --- | --- | --- |
| A | JP 2006-080117 A  (Hitachi AIC Inc.),<br>23 March, 2006 (23.03.06),<br>Full text; all drawings<br>& WO 2006/028073 A1 | 1-7 |
| A | JP 2002-094122 A  (Matsushita Electric Works, Ltd.),<br>29 March, 2002 (29.03.02),<br>Full text; all drawings<br>& US 2003/0189830 A1    & EP 1387412 A1<br>& WO 02/084750 A1 | 1-7 |
| A | JP 2005-136224 A  (Asahi Kasei Electronics Kabushiki Kaisha),<br>26 May, 2005 (26.05.05),<br>Full text; all drawings<br>(Family: none) | 1-7 |

| ☒ | Further documents are listed in the continuation of Box C. | ☐ | See patent family annex. |

| * | Special categories of cited documents: |
| --- | --- |
| "A" | document defining the general state of the art which is not considered   to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
| --- | --- |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search<br>27 December, 2007 (27.12.07) | Date of mailing of the international search report<br>15 January, 2008 (15.01.08) |
| --- | --- |
| Name and mailing address of the ISA/<br>Japanese Patent Office | Authorized officer |
| Facsimile No. | Telephone No. |

Form PCT/ISA/210 (second sheet) (April 2007)

**INTERNATIONAL SEARCH REPORT**

International application No.

PCT/JP2007/074202

C (Continuation). DOCUMENTS CONSIDERED TO BE RELEVANT

| Category* | Citation of document, with indication, where appropriate, of the relevant passages | Relevant to claim No. |
|---|---|---|
| A | JP 2002-040955 A (Sanyo Electric Co., Ltd.), 28 February, 2002 (28.02.02), Full text; all drawings (Family: none) | 1-7 |
| A | JP 2006-059607 A (Sony Corp.), 02 March, 2006 (02.03.06), Full text; all drawings (Family: none) | 1-7 |

Form PCT/ISA/210 (continuation of second sheet) (April 2007)

**EP 2 101 360 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2006011239 A
- JP 2006058486 A
- JP 2005347500 A